# EUROPÄISCHE PATENTANMELDUNG

(11) **EP 1 683 897 A1**
(43) Veröffentlichungstag der Anmeldung: **26.07.2006**
(21) Anmeldenummer: 05026257.5
(22) Anmeldetag: 01.12.2005
(51) Int. Cl.: C30B 25/02, C30B 29/06, C30B 33/12, H01L 21/762

(54) **Halbleiterscheibe mit einer Halbleiterschicht und einer darunter liegenden elektrisch isolierenden Schicht sowie Verfahren zu deren Herstellung**

(30) Priorität: 23.12.2004 DE 102004062356
(71) Anmelder: Siltronic AG, 81737 München (DE)
(72) Erfinder: Dantz, Dirk, Dr., 38154 Königslutter am Elm (DE); Huber, Andreas, Dr., 84518 Garching (DE); Murphy, Brian, 84347 Pfarrkirchen (DE); Wahlich, Reinhold, 84529 Tittmoning (DE)
(74) Vertreter: Baar, Christian

(57) **Zusammenfassung**

Die Erfindung betrifft eine Halbleiterscheibe, die an ihrer Oberfläche eine Halbleiterschicht mit einer Dicke im Bereich von 3 nm bis 200 nm umfasst, wobei diese Halbleiterschicht keine Lochdefekte aufweist, und die eine darunter liegende, daran angrenzende Schicht bestehend aus einem elektrisch isolierenden Material umfasst.

Die Erfindung betrifft auch ein Verfahren zur thermischen Behandlung einer Halbleiterscheibe mit einer Halbleiterschicht und einer darunter liegenden, daran angrenzenden Schicht bestehend aus einem elektrisch isolierenden Material bei einer Temperatur im Bereich von 750 °C bis 1300 °C unter einer inerten oder reduzierenden Atmosphäre, wobei die Atmosphäre zumindest zeitweise eine gasförmige Verbindung des Halbleitermaterials enthält, sodass eine Abscheidung von Halbleitermaterial auf der Oberfläche der Halbleiterschicht stattfindet, dadurch gekennzeichnet, dass sich die Dicke der Halbleiterschicht nach der thermischen Behandlung nicht wesentlich von der Dicke der Halbleiterschicht vor der thermischen Behandlung unterscheidet.

## Beschreibung

Die vorliegende Erfindung bezieht sich auf eine Halbleiterscheibe mit einer Halbleiterschicht ohne Lochdefekte und einer darunter liegenden elektrisch isolierenden Schicht, beispielsweise eine SOI-Scheibe, sowie auf ein Verfahren zu ihrer Herstellung durch eine thermische Behandlung der Halbleiterscheibe.

SOI-Scheiben ("silicon on insulator") werden in der Regel durch Übertragung einer Siliciumschicht von einer so genannten Donorscheibe (engl. "donor wafer") auf eine Trägerscheibe (engl. "handle wafer" oder "base wafer") hergestellt. Verfahren zur Herstellung von SOI-Scheiben mittels Übertragung einer Siliciumschicht sind beispielsweise in EP533551A1, WO98/52216A1 oder WO03/003430A2 beschrieben. SOI-Scheiben umfassen eine Trägerscheibe und eine damit verbundene Silicium-Deckschicht (engl. "top layer" oder "device layer"), die die so genannte aktive Schicht darstellt, die für die Herstellung von elektronischen Bauelementen vorgesehen ist. Entweder besteht die komplette Trägerscheibe aus einem elektrisch isolierenden Material wie Glas oder Saphir oder die Silicium-Deckschicht ist über eine elektrisch isolierende Zwischenschicht, beispielsweise bestehend aus Siliciumoxid (in diesem Fall wird die Zwischenschicht als "buried oxide layer", BOX, bezeichnet), mit der Trägerscheibe verbunden. Im letzteren Fall muss die Trägerscheibe kein Isolator sein, es kann sich beispielsweise um eine Halbleiterscheibe, vorzugsweise eine Siliciumscheibe handeln.

An die Silicium-Deckschicht werden sehr hohe Anforderungen gestellt. Beispielsweise soll die Deckschicht keine Lochdefekte aufweisen. Dabei handelt es sich um Löcher in der Deckschicht, die unter anderem dadurch entstehen können, dass die von der Donorscheibe übertragene Schicht COPs ("crystal originated particles"; Vakanzenagglomerate) enthält, die eine kritische Größe überschreiten. Auch Metallkontaminationen oder Fehler beim Verbinden der Donorscheibe mit der Trägerscheibe können zu HF-Defekten führen. Bei einer Behandlung der Deckschicht mit wässriger Flusssäure-Lösung (HF) kann diese durch die Löcher zur Siliciumoxidschicht vordringen und diese lokal auflösen. Das Vorhandensein von Lochdefekten beeinträchtigt die Funktion von Bauelementen, die auf der Deckschicht hergestellt werden (A. J. Auberton-Hervé, T. Barge, F. Metral, M. Bruel, B. Aspar, H. Moriceau, The Electrochem. Soc. PV98-1 (1998) 1341).

Durch COPs hervorgerufene Lochdefekte lassen sich weitgehend vermeiden, wenn epitaktisch beschichtete oder COP-freie Siliciumscheiben als Donorscheiben verwendet werden. Lochdefekte, die durch Metallkontaminationen hervorgerufen werden, können durch eine mehrstufige Temperaturbehandlung in bestimmten Temperaturbereichen und mit streng definierten Aufheiz- und Abkühlraten (EP1193739A2, EP1193749A2) reduziert werden. Die dritte Gruppe von Lochdefekten, die durch Fehler beim Verbinden der Donorscheibe mit der Trägerscheibe verursacht werden, kann reduziert werden, indem die Partikel-Kontamination der Träger- und Donorscheibe vor dem Verbinden auf ein geringst mögliches Maß beschränkt wird. Die Erfahrung zeigte aber, dass die Herstellung einer SOI-Scheibe, die völlig frei von Lochdefekten ist, in der Praxis nicht möglich ist.

Aus EP971395A1 ist ein Verfahren bekannt, in dem die Dicke der Siliciumschicht einer SOI-Scheibe nach ihrer Übertragung auf die Trägerscheibe durch Abscheidung einer epitaktischen Schicht deutlich erhöht wird, beispielsweise von 0,5 µm auf 2 µm. Für die meisten Anwendungen im Bereich der Mikroelektronik werden aber möglichst dünne Halbleiterschichten benötigt.

Weiterhin ist aus WO00/63954A1 ein Verfahren bekannt, bei dem die Siliciumschicht einer SOI-Scheibe bei hoher Temperatur einer Ätzbehandlung unter einer ätzenden Atmosphäre, beispielsweise mit einem Halogenwasserstoff unterzogen wird, wobei die Atmosphäre zusätzlich ein Silan enthalten kann. Dieses Verfahren wird eingesetzt, um die Oberflächenrauhigkeit und ggf. die Dicke der Siliciumschicht zu reduzieren. (Ähnliche Verfahren sind auch für die Reduzierung der Oberflächenrauhigkeit herkömmlicher Siliciumscheiben bekannt, siehe beispielsweise EP1160360A1.)

Jeder Lochdefekt, der sich vor der Herstellung elektronischer Bauelemente auf der Halbleiterscheibe befindet, führt zu einem nicht funktionsfähigen Bauelement. Daher ist die Vermeidung auch der geringsten Anzahl von Lochdefekten von erheblicher wirtschaftlicher Bedeutung. Daher stellte sich die Aufgabe, eine SOI-Scheibe mit dünner Halbleiterschicht herzustellen, die bei der Herstellung elektronischer Bauelemente zu einer erhöhten Ausbeute führt.

Die Aufgabe wird gelöst durch eine Halbleiterscheibe, die an ihrer Oberfläche eine Halbleiterschicht mit einer Dicke im Bereich von 3 nm bis 200 nm umfasst, wobei diese Halbleiterschicht keine Lochdefekte aufweist, und die eine darunter liegende, daran angrenzende Schicht bestehend aus einem elektrisch isolierenden Material umfasst.

Als Lochdefekte werden im Rahmen der Erfindung alle Löcher in der Halbleiterschicht bezeichnet, die sich von der Oberfläche der Halbleiterschicht bis zur Grenzfläche der Halbleiterschicht zur Isolatorschicht erstrecken. Diese Löcher lassen sich mit geeigneten Ätzverfahren, optischen Methoden (z. B.

Lichtstreuverfahren, optische Mikroskopie) oder Rastermikroskopie (z. B. Rasterelektronenmikroskopie = REM, Transmissionselektronenmikroskopie = TEM oder Rasterkraftmikroskopie = AFM) detektieren.

Erfindungsgemäß hergestellte Halbleiterscheiben weisen keine Lochdefekte und keine dadurch bedingten Ausbeuteverluste bei der Herstellung elektronischer Bauelemente auf.

Das Halbleitermaterial der Schicht kann beispielsweise Silicium, Germanium oder Silicium-Germanium sein. In der Regel ist das Halbleitermaterial der Schicht monokristallin. Das Halbleitermaterial der Schicht kann auch verspannt sein, beispielsweise verspanntes Silicium.

Die unter der Schicht aus dem Halbleitermaterial liegende Schicht kann aus einem beliebigen elektrisch isolierenden Material bestehen. Die Schicht kann eine Trägerscheibe sein, die aus einem elektrisch isolierenden Material besteht, beispielsweise Glas, Quarz oder Saphir. Bei der Schicht kann es sich aber auch um eine dünne Schicht handeln, die wiederum auf einer Trägerscheibe aufliegt, die beispielsweise wieder aus einem Halbleitermaterial besteht. Die dünne elektrisch isolierende Schicht besteht vorzugsweise aus einem Oxid des Halbleitermaterials, aus dem die Halbleiterschicht oder die Trägerscheibe besteht. Das Halbleitermaterial der Trägerscheibe ist in der Regel Silicium.

Besonders bedeutend sind sog. SOI-Scheiben, bei denen die Halbleiterschicht aus einkristallinem Silicium, die dünne elektrisch isolierende Schicht aus Siliciumoxid und die Trägerscheibe wiederum aus polykristallinem, meist aber einkristallinem Silicium besteht. Es sind auch ähnlich aufgebaute Halbleiterscheiben bekannt, bei denen die Halbleiterschicht aus Germanium (GOI-Scheiben) oder Silicium-Germanium (SGOI-Scheiben) besteht.

Im Fall von SOI-Scheiben und ähnlichen Scheiben, bei denen die Halbleiterschicht praktisch nicht und die Schicht aus elektrisch isolierendem Material gut von Flusssäure (HF) angegriffen wird, lassen sich Lochdefekte durch eine 15minütige Behandlung mit einer 49%igen wässrigen Flusssäurelösung präparieren und anschließend auszählen. Die Flusssäure führt zu Unterätzungen der Halbleiterschicht. Dies geschieht an den Stellen, an denen die Halbleiterschicht stark gestört oder nicht vorhanden ist, und an denen die Flusssäure direkt an die elektrisch isolierende Schicht gelangen kann. Im Fall der genannten Scheibentypen werden die Lochdefekte daher auch als HF-Defekte bezeichnet.

Die Erfindung bezieht sich auch auf ein Verfahren zur thermischen Behandlung einer Halbleiterscheibe mit einer Halbleiterschicht und einer darunter liegenden, daran angrenzenden Schicht bestehend aus einem elektrisch isolierenden Material bei einer Temperatur im Bereich von 750 °C bis 1300 °C unter einer inerten oder reduzierenden Atmosphäre, wobei die Atmosphäre zumindest zeitweise eine gasförmige Verbindung des Halbleitermaterials enthält, sodass eine Abscheidung von Halbleitermaterial auf der Oberfläche der Halbleiterschicht stattfindet, dadurch gekennzeichnet, dass sich die Dicke der Halbleiterschicht nach der thermischen Behandlung nicht wesentlich von der Dicke der Halbleiterschicht vor der thermischen Behandlung unterscheidet.

Vorzugsweise wird das Verfahren verwendet, um eine Halbleiterscheibe herzustellen, deren Halbleiterschicht frei von Lochdefekten ist.

Vorzugsweise unterscheidet sich die Dicke der Halbleiterschicht nach der thermischen Behandlung um nicht mehr als 20 %, besonders bevorzugt um nicht mehr als 10 %, von der Dicke der Halbleiterschicht vor der thermischen Behandlung.

Erfindungsgemäß werden die nach der Herstellung der Halbleiterscheibe in der Halbleiterschicht vorhandenen Lochdefekte nachträglich ausgeheilt, indem die Halbleiterscheibe einer Atmosphäre ausgesetzt wird, die unter den gewählten Bedingungen die Abscheidung geringer Mengen des Halbleitermaterials auf der Halbleiterschicht erlaubt und gleichzeitig die Oberflächendiffusion auf der Halbleiterschicht anregt. Dadurch werden Löcher in der Halbleiterschicht unabhängig von ihrer Herkunft nachträglich ausgeheilt, ohne dass die Dicke der Halbleiterschicht wesentlich zunimmt.

Es hat sich herausgestellt, dass Lochdefekte in der Halbleiterschicht besonders effektiv ausgeheilt werden können, wenn eine geringfügige Abscheidung von Halbleitermaterial auf der Oberfläche stattfindet oder wenn Abscheidung und Abtrag im Gleichgewicht stehen. Dies kommt erfindungsgemäß dadurch zum Ausdruck, dass sich die Dicke der Halbleiterschicht während der Behandlung nicht wesentlich verändert. Ein im Wesentlichen abtragendes Verfahren, wie in WO00/63954A1 beschrieben, ist zwar zum Glätten der Oberfläche, nicht aber zum Verschließen der Lochdefekte geeignet. Andererseits ist das in EP971395A1 beschriebene Verfahren mit einer deutlichen Erhöhung der Schichtdicke der Halbleiterschicht verbunden und daher für die meisten Anwendungen ungeeignet, da in der Regel möglichst dünne Schichten benötigt werden. Daher ist es erfindungsgemäß erforderlich, dass sich die Schichtdicke während des Verfahrens nicht wesentlich verändert.

Kern des erfindungsgemäßen Verfahrens ist eine thermische Behandlung unter einer inerten oder reduzierenden Atmosphäre, die eine gasförmige Verbindung des Halbleitermaterials enthält, wobei zumindest zeitweise eine Abscheidung von Halbleitermaterial auf der Oberfläche der Halbleiterschicht stattfindet. Das Halbleitermaterial ist das Material, aus dem die Halbleiterschicht besteht. Besteht die Halbleiterschicht beispielsweise aus Silicium, können als gasförmige Verbindung des Halbleitermaterials beispielsweise Silane wie z. B. Dichlorsilan (SiH₂Cl₂) eingesetzt werden.

Die Abscheidung von Halbleitermaterial findet in einer Umgebung statt, in der die Oberflächendiffusion auf der Oberfläche der Halbleiterschicht angeregt wird. Da eine Vergrößerung der Dicke der Halbleiterschicht in der Regel nicht gewünscht ist, werden die Bedingungen vorzugsweise so gewählt, dass eine sehr geringe Abscheiderate resultiert. Vorzugsweise werden die Parameter der Abscheidung so gewählt, dass Abscheideraten im Bereich von 5 bis 50 nm/min resultieren, die Dauer der Abscheidung wird an die Abscheiderate angepasst, sodass die Lochdefekte verschlossen werden und gleichzeitig die geforderte Schichtdickenänderung nicht überschritten wird.

Unter Bedingungen, die die Oberflächendiffusion anregen, führt schon die Abscheidung von geringsten Mengen des Halbleitermaterials zu einer vergleichsweise hohen Anzahl von beweglichen Atomen auf der Oberfläche der Halbleiterschicht. Im Bestreben, die Gesamtenergie des Systems zu minimieren, d. h. eine glatte, geschlossene Oberfläche zu erzeugen, lagern sich die beweglichen Atome bevorzugt an den ihnen zugänglichen gestörten oder geschwächten Bereichen der Halbleiterschicht an. Dies führt dazu, dass im Verlauf der thermischen Behandlung die gestörten Stellen oder Lochdefekte in der Halbleiterschicht ausgeheilt bzw. verschlossen werden. Die Beweglichkeit der Atome des Halbleitermaterials steigt mit zunehmender Temperatur und mit sinkendem Druck in einer inerten oder reduzierenden Atmosphäre, die vorzugsweise aus Wasserstoff oder Edelgasen wie z. B. Argon oder Gemischen davon besteht.

Der Druck liegt während der thermischen Behandlung vorzugsweise im Bereich von 10⁻⁵ Pa bis 10⁴ Pa. Die Dauer der gesamten thermischen Behandlung liegt vorzugsweise zwischen einer Sekunde und einer Stunde. Die Abscheidung kann konstant während der gesamten Dauer der thermischen Behandlung, in Intervallen oder auch nur temporär erfolgen. Der Widerstand der abgeschiedenen Schicht kann durch Zugabe von dotierstoffhaltigen Gasen (z. B. Diboran oder Phosphin) eingestellt werden.

In einer bevorzugten Ausführungsform der Erfindung enthält die Atmosphäre während der thermischen Behandlung keine oxidierenden Bestandteile.

In einer anderen bevorzugten Ausführungsform des erfindungsgemäßen Verfahrens enthält die Atmosphäre zumindest zeitweise auch einen ätzenden Bestandteil, sodass Material von der Halbleiterschicht abgetragen wird. Der ätzende Bestandteil kann beispielsweise eine Halogenverbindung sein, z. B. Fluorwasserstoff (HF), Chlorwasserstoff (HCl), Bromwasserstoff (HBr), Iodwasserstoff (HI), Schwefelhexafluorid (SF₆), Stickstofftrifluorid (NF₃), Tetrafluormethan (CF₄) oder Hexafluorethan (C₂F₆) sein. Um den Materialabtrag genau steuern zu können, werden die Parameter der Abtragsreaktion (z. B. Fluss des ätzenden Bestandteils) so gewählt, dass sehr geringe Abtragsraten im Bereich von 1 bis 20 nm/min resultieren.

Der ätzende Bestandteil und die gasförmige Verbindung des Halbleitermaterials können gleichzeitig in der Atmosphäre enthalten sein, sodass auf der Halbleiterschicht gleichzeitig Halbleitermaterial abgeschieden und abgetragen wird. Die Atmosphäre kann andererseits aber auch abwechselnd die Verbindung des Halbleitermaterials und den ätzenden Bestandteil enthalten, sodass abwechselnd Halbleitermaterial abgeschieden und abgetragen wird. Die Reihenfolge der beiden Teilschritte ist beliebig, und die Teilschritte können auch einmal oder mehrmals wiederholt werden.

### Beispiele

### Beispiel 1

Eine gereinigte SOI-Scheibe mit einer Silicium-Deckschicht der Orientierung <001> und einer Dicke von 120 nm wurde in einen unterdruckfähigen CVD-Reaktor geladen. Bei einer Temperatur von 1050 °C wurde der auf der Scheibenoberfläche verbleibende Sauerstoff und Kohlenstoff mittels Spülung mit Wasserstoff-Gas entfernt. Unter Verwendung von Dichlorsilan (SiH₂Cl₂) wurde bei einer Temperatur von 1050 °C und einem Druck von 2,7 kPa mit einer Abscheiderate von 10 nm/min Silicium abgeschieden. Die Abscheidung wurde auf die erste Minute begrenzt. Anschließend wurde die thermische Behandlung unter den gleichen Bedingungen ohne weitere Abscheidung fortgeführt. Als Trägergas wurde ein Gemisch aus Argon und Wasserstoff verwendet. Nach dem Ende der thermischen Behandlung wurde die SOI-Scheibe auf HF-Defekte untersucht. Die SOI-Scheibe wies keinen HF-Defekt auf.

### Beispiel 2

Eine gereinigte SOI-Scheibe mit einer Silicium-Deckschicht der Orientierung <001> und einer Dicke von 120 nm wurde in einen unterdruckfähigen CVD-Reaktor geladen. Bei einer Temperatur von 1050 °C wurde der auf der Scheibenoberfläche verbleibende Sauerstoff und Kohlenstoff mittels Spülung mit Wasserstoff-Gas entfernt. Unter Verwendung von Dichlorsilan (SiH₂Cl₂) wurde bei einer Temperatur von 1050 °C und einem Druck von 4,0 kPa in zwei Intervallen mit einer Abscheiderate von 10 nm/min im ersten bzw. 20 nm/min im zweiten Intervall Silicium abgeschieden. Das erste Intervall dauerte 30 Sekunden, das zweite 15 Sekunden. Nach den Abscheidungen wurden die Prozesse jeweils ohne weitere Abscheidung fortgeführt. Als Trägergas wurde Wasserstoff verwendet. Nach dem Ende der thermischen Behandlung wurde die SOI-Scheibe auf HF-Defekte untersucht. Die SOI-Scheibe wies keinen HF-Defekt auf.

## Patentansprüche

1. Halbleiterscheibe, die an ihrer Oberfläche eine Halbleiterschicht mit einer Dicke im Bereich von 3 nm bis 200 nm umfasst, wobei diese Halbleiterschicht keine Lochdefekte aufweist, und die eine darunter liegende, daran angrenzende Schicht bestehend aus einem elektrisch isolierenden Material umfasst.

2. Halbleiterscheibe gemäß Anspruch 1, wobei die Halbleiterschicht Silicium enthält und wobei das elektrisch isolierende Material Siliciumoxid ist.

3. Verfahren zur thermischen Behandlung einer Halbleiterscheibe mit einer Halbleiterschicht und einer darunter liegenden, daran angrenzenden Schicht bestehend aus einem elektrisch isolierenden Material bei einer Temperatur im Bereich von 750 °C bis 1300 °C unter einer inerten oder reduzierenden Atmosphäre, wobei die Atmosphäre zumindest zeitweise eine gasförmige Verbindung des Halbleitermaterials enthält, sodass eine Abscheidung von Halbleitermaterial auf der Oberfläche der Halbleiterschicht stattfindet, **dadurch gekennzeichnet, dass** sich die Dicke der Halbleiterschicht nach der thermischen Behandlung nicht wesentlich von der Dicke der Halbleiterschicht vor der thermischen Behandlung unterscheidet.

4. Verfahren zur thermischen Behandlung einer Halbleiterscheibe gemäß Anspruch 3, **dadurch gekennzeichnet, dass** mit dem Verfahren eine Halbleiterscheibe gemäß Anspruch 1 hergestellt wird.

5. Verfahren gemäß einem der Ansprüche 3 oder 4, **dadurch gekennzeichnet, dass** sich die Dicke der Halbleiterschicht nach der thermischen Behandlung um nicht mehr als 20 % von der Dicke der Halbleiterschicht vor der thermischen Behandlung unterscheidet.

6. Verfahren gemäß Anspruch 5, **dadurch gekennzeichnet, dass** sich die Dicke der Halbleiterschicht nach der thermischen Behandlung um nicht mehr als 10 % von der Dicke der Halbleiterschicht vor der thermischen Behandlung unterscheidet.

7. Verfahren gemäß einem der Ansprüche 3 bis 6, **dadurch gekennzeichnet, dass** die Atmosphäre keine oxidierenden Bestandteile enthält.

8. Verfahren gemäß einem der Ansprüche 3 bis 6, **dadurch gekennzeichnet, dass** die Atmosphäre zumindest zeitweise einen ätzenden Bestandteil enthält, sodass Material von der Halbleiterschicht abgetragen wird.

9. Verfahren gemäß Anspruch 8, **dadurch gekennzeichnet, dass** der ätzende Bestandteil eine Halogenverbindung ist.

10. Verfahren gemäß einem der Ansprüche 8 oder 9, **dadurch gekennzeichnet, dass** die Atmosphäre zumindest zeitweise gleichzeitig die Verbindung des Halbleitermaterials und den ätzenden Bestandteil enthält, sodass auf der Halbleiterschicht gleichzeitig Halbleitermaterial abgeschieden und abgetragen wird.

11. Verfahren gemäß einem der Ansprüche 8 oder 9, **dadurch gekennzeichnet, dass** die Atmosphäre abwechselnd die Verbindung des Halbleitermaterials und den ätzenden Bestandteil enthält, sodass abwechselnd Halbleitermaterial abgeschieden und abgetragen wird.

12. Verfahren gemäß einem der Ansprüche 3 bis 11, **dadurch gekennzeichnet, dass** die thermische Behandlung in einem Druckbereich von 10⁻⁵ Pa bis 10⁴ Pa liegt.
